# EUROPEAN PATENT APPLICATION

(11) **EP 3 761 341 A1**
(43) Date of publication of application: **06.01.2021**
(21) Application number: 19184246.7
(22) Date of filing: 03.07.2019
(51) Int. Cl.: H01J 37/32, H05H 1/24

(54) **SPATIALLY CONTROLLED PLASMA DELIVERY APPARATUS**

(71) Applicant: Nederlandse Organisatie voor toegepast- natuurwetenschappelijk Onderzoek TNO, 2595 DA 's-Gravenhage (NL)
(72) Inventor: Creyghton, Yves Lodewijk Maria, 2595 DA 's-Gravenhage (NL); Rijfers, Andries, 2595 DA 's-Gravenhage (NL)
(74) Representative: V.O.

(57) **Abstract**

A plasma delivery apparatus, comprising:
a plasma source provided in an outer face of the delivery apparatus, the outer face arranged for facing a substrate to be treated;
a transport mechanism configured to transport the substrate and the outer face relative to each other;
the plasma source comprising a gas inlet to provide gas flow to a plasma generation space;
the plasma generation space fluidly coupled to at least one plasma delivery port arranged in the outer face; wherein the plasma generation space is bounded by an outer face of a working electrode and a counter electrode; the working electrode comprising a dielectric layer;
at least one plasma exhaust port provided in the outer face and distanced from the plasma delivery port, to exhaust plasma flowing along the outer face via said plasma exhaust port,
wherein said at least one plasma delivery port and at least one plasma exhaust port are arranged to provide at least two contiguous plasma flows flowing in opposite directions that are each generated by a respective one of at least two working electrodes; and a switch circuit for switchably providing an electric voltage to the at least two working electrodes, wherein the switch circuit operates in unison with the transport mechanism.

## Description

### Field of the invention

The invention relates to a plasma delivery apparatus, in particular a plasma delivery apparatus, comprising a plasma source provided in an outer face of the delivery apparatus, the outer face arranged for facing a substrate to be treated; a transport mechanism configured to transport the substrate and the outer face relative to each other; the plasma source comprising a gas inlet to provide gas flow to a plasma generation space; the plasma generation space fluidly coupled to at least one plasma delivery port arranged in the outer face; wherein the plasma generation space is bounded by an outer face of a working electrode and a counter electrode; the working electrode comprising a dielectric layer; and at least one plasma exhaust port provided in the outer face and distanced from the plasma delivery port, to exhaust plasma flowing along the outer face via said plasma exhaust port. Such a device is known from WO2015199539.

### BACKGROUND

Plasma treatment of surfaces has many useful applications, including discharging of surfaces, modification of surface energy improving wettability or adhesion of materials as paints glues and other coatings, the cleaning and/or deactivation of bacterial cells on surfaces as well as being included as part of larger assemblies for surface treatments used in for example semi-conductor industry, such as chemical vapor deposition, plasma etching, atomic layer deposition (ALD) and atomic layer etching (ALE) devices. Using a suitable gas flow from an inlet, the plasma generated in these spaces may be transported to the aperture from which it is delivered to the surface of a substrate to be processed.

In various spatial ALD (SALD) applications, there is need for local or selective thin film deposition on foil or rigid plate substrates while they move. For example, a desired deposition pattern may be a series of generally rectangular areas of deposition without depositing between those areas. For example, when electronic devices such as PV cells or battery electrodes are covered with dielectric layers it may be desirable to keep parts uncovered for making suitable electrical connections. Another example may be deposited conductive film areas that should be isolated from each other. Another example may be a series of adjacent sheets to be covered with thin layers in an atomic layer deposition process. This may require long purge times in order to remove precursor gas between the sheets; and it could be desirable to stop supplying a co-reactant in areas between neighboring sheets to overcome long purge times, thus enabling faster deposition.

### SUMMARY OF THE INVENTION

Among others, it is an object to provide for a plasma source and/or a surface processing apparatus that is able to provide a spatially controlled selective deposition. To this end a plasma delivery apparatus is provided according to claim 1. A plasma delivery apparatus comprises a plasma source provided in an outer face of the delivery apparatus, the outer face arranged for facing a substrate to be treated. A transport mechanism configured to transport the substrate and the outer face relative to each other and the plasma source comprising a gas inlet to provide gas flow to a plasma generation space.

The plasma generation space is fluidly coupled to at least one plasma delivery port arranged in the outer face; wherein the plasma generation space is bounded by an outer face of a working electrode and a counter electrode; the working electrode comprising a dielectric layer and wherein at least one plasma exhaust port is provided in the outer face and distanced from the plasma delivery port, to exhaust plasma flowing along the outer face via said plasma exhaust port. The at least one plasma delivery port and at least one plasma exhaust port are arranged to provide at least two contiguous plasma flows flowing in opposite directions that are each generated by a respective one of at least two working electrodes; and a switch circuit switchably provides an electric voltage to the at least two working electrodes, wherein the switch circuit operates in unison with the transport mechanism.

The plasma source is particularly suitable for use in atomic layer deposition (ALD) where a substrate is repetitively exposed to a sequence of reactants (at least two) providing surface limited growth of a layer. The plasma source can be used to provide one or more of the successive reactants and a series of plasma sources may be used. The plasma source providing very reactive plasma species makes it possible to reduce the space and/or the time needed for co-reactants to react with the surface until saturation. This allows to increase the substrate speed in spatial ALD processing. In other embodiments, the plasma source may be used for other atmospheric pressure plasma surface treatment applications where chemical reactive plasma species (radicals, ions, electronically and vibrationally excited species) are needed to react with the surface. Examples of such applications are cleaning or etching by oxidation (for example using O radicals) or reduction (using H or NH radicals), activation for adhesion improvement and plasma-enhanced chemical vapor deposition (PECVD).

### BRIEF DESCRIPTION OF THE DRAWINGS

These and other objects and advantageous aspects will become apparent from a description of exemplary embodiments with reference to the following figures.
Figure 1 (a and b) and 2 (a and b) show a schematic view of a plasma delivery apparatus, in various switching modes;
Figure 3a and b shows side views of the modifications of the plasma delivery apparatus shown in Figures 1 and 2;
Figure 4 shows another embodiment.
Figure 5 (a and b) shows a planar view of an outer face of the plasma delivery apparatus; and
Figure 6 shows various schematic cross sectional views of a preferred embodiment of the working electrode.

### DETAILED DESCRIPTION OF EXEMPLARY EMBODIMENTS.

The gas composition may comprise N₂, O₂, H₂, N₂O, NO or CO₂ and mixtures to produce radicals such as N, O, H, OH and NH.

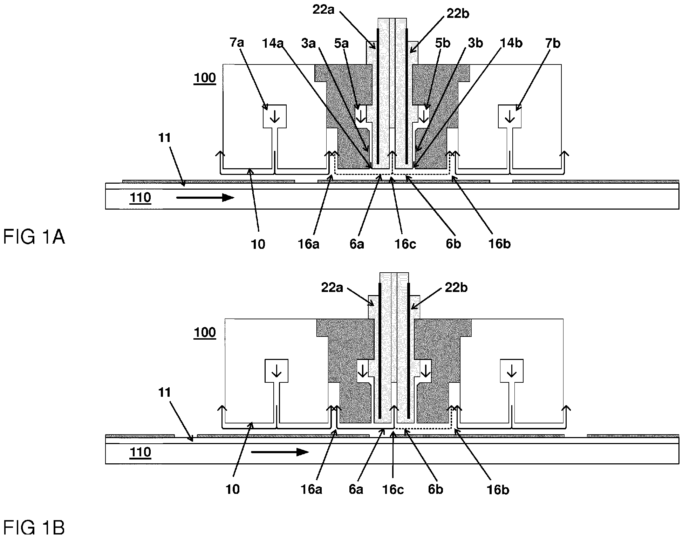

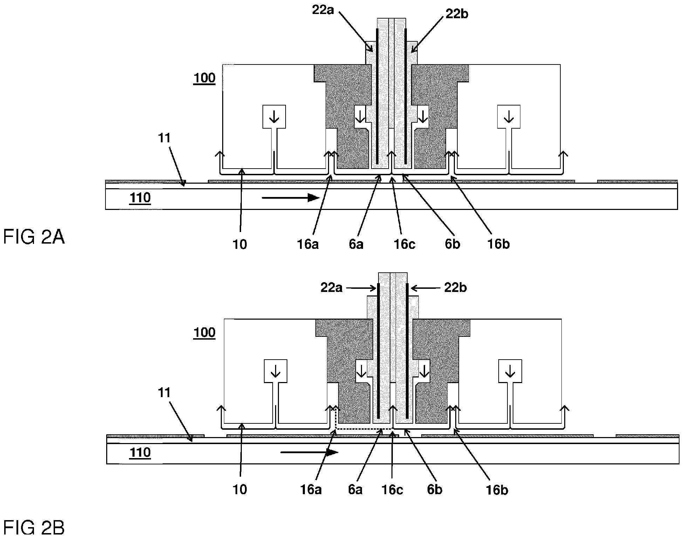

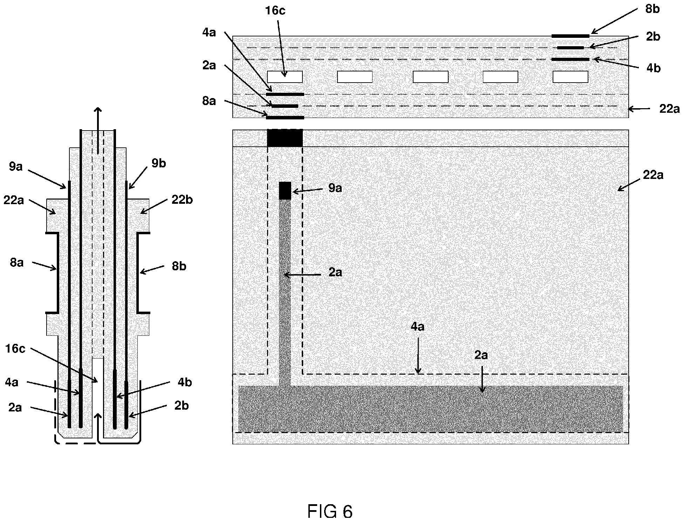

Figure 1a shows a cross-section of an exemplary embodiment of a plasma delivery apparatus 100 for processing a substrate 11. Substrate 11 may be part of a flexible foil or a rigid plate such as glass or a semi-conductor wafer for example. In the illustrated embodiment the surface processing apparatus has a flat planar outer face 10 that faces substrate 11, but alternatively a curved shape may be used. In exemplary embodiments the distance between outer face 10 and substrate 11 may be in the range of 0.01 to 0.2 mm or at most 0.5 mm. Plasma delivery ports, formed by apertures 14a, 14b in outer face 10 are used to feed atmospheric plasma (6a, 6b) to the space between substrate 11 and outer face 10. As used herein atmospheric means not effectively vacuum, e.g. absolute pressures between 0.1 and 10 Bar. In an embodiment apertures 14a, 14b are 0.1 mm wide but this may depend on design specifics. Apertures 14a,14b, which may also be referred to as nozzles or plasma delivery ports, extend along a line perpendicular to the plane of the drawing. In this embodiment, apertures 14a and 14b are two line-shaped gas flow driven remote plasma delivery ports, which are placed in parallel in the outer face 10 and proving a sharp spatial limitation of the plasma. During passage of the substrate 11, plasma delivery ports 14a, 14b and plasma exhaust port 16c (see Fig 1) provide contiguous plasma flows 6a, 6b flowing in opposite directions that are each generated by respective working electrodes 22a, 22b. Working electrodes are electrically connected to a switch circuit (not shown) to switchably provide an electric voltage to two working electrodes 22a, 22b. Working electrodes 22a, 22b are formed by line shaped conductive layers 2a, 2b (See Fig 6) covered by a dielectric layer. Switching working electrodes 22a, 22b are operated in unison with the transport mechanism 110 for moving substrate 11. A line shaped deposition-free area is thus obtained with a sharp boundary of the plasma active area using two parallel flows: one chemical reactive radical-enriched flow 6b (see Fig 1B) which is plasma-activated e.g. by working electrode 22b and one non-reactive gas flow 6a due to switching off parallel and opposite non-activated working electrode 22a. The switching may be alternated switching, see Fig 2A where both working electrodes are switched off; and Fig 2B where working electrode 22a and 22b are inversely switched to Figure 1B i.e. working electrode 22a is switched on and working 22b is switched off. Switching the left side high voltage terminal of working electrode 22a creates a flux of radicals from the left side of the plasma source. Alternatively, switching the right side high voltage terminal of working electrode 22b creates a flux of radicals from the right side of the plasma source.

The switching sequence indicated in Fig.1A-B and Fig.2A-B (on-on, off-on, off-off, on-off), with substrate 11 moving with constant velocity, can thus result in a locally changed profile of the plasma flux received by the substrate 11 leaving a narrow strip shaped substrate area untreated by plasma. When this profiled radical flux is used as the co-reactant of a spatial ALD process, separated thin film areas may be obtained. For obtaining relatively thin strips the plasma exhaust ports and plasma delivery ports are formed by slits that are only distanced over a thickness of a working electrode 22a, 22b, a planar form that has a relatively thin dielectric layer burying a metal strip or metal film.

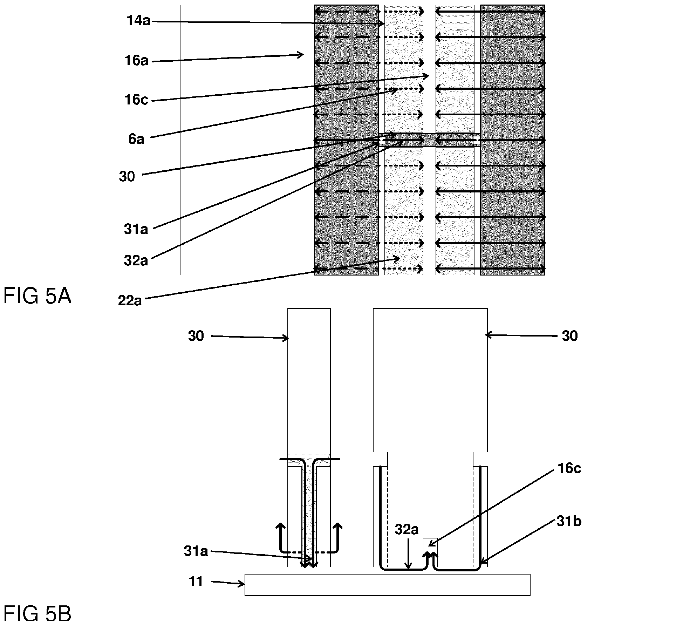

The sharp edge profiled radical flux can thus be used to create narrow line-shaped deposition free areas separating uniform thickness film areas. The width of typical edge profiles (10-90% of thickness) can be in the range 0.2-0.5 mm. Line-shaped areas in the perpendicular direction along the direction of movement, may be desired as well in order to obtain separated rectangular shaped thin film areas. This can be obtained with provisions of the plasma source as described with Fig. 5.

For providing the narrowest line shaped area, the process step with both plasma sources switched off can be omitted. In addition, the sequence can be operated while omitting the step with both sources switched on, thus exclusively switching between the left-hand plasma source and the righthand plasma source. Alternatively, when both plasma sources are switched on, the substrate can be moved at twice the velocity to provide the same radical flux to a substrate.

In order to obtain layers with uniform properties such as uniform layer thickness and uniform layer composition, it is beneficial to supply a constant local flux of radicals (number of radicals per mm² per second) to the moving substrate from a first edge when one plasma flow is activated (e.g. plasma flow 6a in Fig. 2B) to a second edge when the opposite plasma flow is activated (e.g. 6b in Fig. 1B). In order to supply a uniform radical flux from a sharp edge, it may be beneficial to reduce temporally the relative velocity between substrate and plasma source. As varying the velocity may be unpractical, the power density of the delivered plasma can be varied for obtaining a uniform radical flux. The power density of the plasma can be varied by varying the frequency or the amplitude of the applied voltage. A variable voltage frequency or amplitude can be applied to the plasma sources so as to apply the same radical flux to substrates moving with a varying velocity. This can be useful, for example in sheet-to-sheet spatial ALD applications where substrates or the SALD injector head move back and forward in an oscillatory manner. Another application of a variable voltage frequency or amplitude are layers with controlled large edge profiles or layers with a gradient extending over the full length of the deposited layer.

A new insight of the inventors is that a chemical reactive radical enhanced first laminar gas flow does practically not mix with a parallel second not reactive laminar gas flow within the short period of radical life times (<0.1 ms) at high (e.g. atmospheric) gas pressures. The plasma is switched on and off in very short time (again <0.1 ms) thus the same plasma source can be alternatively used for generation of short living radicals or a non-reactive (inert) push gas flow. A further fundamental insight applied here is that transport of radicals by sufficient high flow is dominant over transport by diffusion.

The plasma delivery apparatus 100 comprises a transport mechanism for moving substrate 11, a first and second counter electrode 3a, 3b of electrically conductive material (preferably grounded or at the same potential as the substrate if the substrate is not grounded). A plasma generating space is formed respectively between counter electrode 3a, 3b and opposite sides of the working electrode 22a, 22b. The counter electrode may be formed by stainless steel, Titanium (preferred), or conductive ceramic, e.g. hydrogen doped SiC. Transverse to the plane of drawing counter electrode 3a, 3b, the working electrode 22 extends at least along the length of apertures 14a, 14b and 16c.

Transport mechanism 110 for substrate 11 is shown only symbolically. By way of example, it may comprise a conveyor belt for transporting substrate 11, or a table and a motor to drive the table, or a roll to roll (R2R) mechanism may be used comprising a first and second of rotating roll from which a substrate 11 such as a foil is rolled off and onto respectively. In other embodiments the transport mechanism may comprise a motor to move substrate 11 with respect to the assembly of working electrodes 22 and counter electrodes 3a, 3b or vice versa. In another embodiment the electrodes may be integrated in a rotating drum, apertures exhausting from the surface of the drum, in which case the transport mechanism may comprise a motor to directly or indirectly drive rotation of the drum.

The dielectric barrier discharge plasma is generated in pure gas or a mixture of gases (N₂, O₂, H₂, N₂O, NO or CO₂) supplied from gas inlets 5a, 5b. The plasma generated in the plasma generation spaces between ground electrodes 3a, 3b and working electrodes 22a, 22b may extend to surface portions of dielectric layers covering line shaped conductive layers 2a, 2b (shown in Fig. 6) directly facing the substrate as surface dielectric barrier discharge (SDBD) plasma. Keeping the width of working electrodes 22a, 22b facing a substrate sufficiently small, the ionizing plasma is not transferred to this substrate even when this substrate is conductive and at very small distance. In this way, remote SDBD plasma can be effectively generated at very short distance from the substrate without using the substrate as electrode. This is important for applications where a high radical flux is needed without damaging the substrate by direct plasma. The optimum width of the working electrodes 22a, 22b depends on the spatial gap between the dielectric layer of working electrode 22 and the substrate. For a gap between working electrode and substrate in the range 0.1-0.3 mm, the possible width of working electrode 22a, 22b avoiding direct plasma to the substrate is in the range 0.5-2.0 mm, preferably 0.7-1.5 mm.

The counter electrodes 3a, 3b may be kept at a constant potential, e.g. ground potential, and a high frequency potential may be applied to working electrodes 22a, 22b.

Atmospheric plasma tends to extinguish quickly, even within a period of the high frequency electric voltage. As result, the plasma can be re-initiated periodically during each half cycle of an applied alternating or pulsed voltage. Plasma may contain free electrons, ions, electronic and vibrational excited molecules, photons and radicals besides neutral molecules. Many of the plasma species are chemical reactive and can be denoted as Reactive Plasma Species (RPS). The nature and concentration of RPS depend on gas composition and electrical plasma conditions. Furthermore, fast recombination processes cause strong variations of RPS both as function of space and as function of time. Other examples of RPS are electronic or vibrational excited atoms and molecules.

A single gas source (not shown) may be used coupled to both inlets 5a, 5b. The gas source may comprise sub-sources for the different components of the gas and a gas mixer with inputs coupled to the sub-sources and outputs coupled to inlets 5a, 5b. Switching working electrodes 22a and 22b may cause small pressure changes between apertures 14a and 14b. In order to avoid changes in the gas flow rates through respective apertures 14a and 14b, mass flow controllers may be used coupled to respective gas inlets 5a and 5b.

The gas flow rate from inlets 5a, 5b (e.g. mass or volume per second) may be selected dependent on the desired rate of reactive plasma species on substrate 11. In an example a rate of 1000-2000 cubic mm per second, per mm length of aperture per inlet is used, or in a corresponding mass flow range obtained by assuming a pressure of one atmosphere and a temperature of 25 degrees centigrade.

The gas flow speed through the spaces between the working electrodes 22a, 22b and counter electrodes 3a, 3b corresponds to the flow rate divided by the cross-section area of the spaces (thickness times width). By keeping the cross section area small, a high flow speed is realized. High flow speed has the advantage that less loss will occur due to recombination of radicals and ions prior to reaction on substrate 11. Another advantage of the high gas flow speeds is the limited time for gas diffusion between reactive and non-reactive gas flows 6a and 6b delivered by apertures 14a and 14b.

The plasma source is flanked by purge gas injectors 7a and 7b that confine the plasma flow. The plasma source preferably has a symmetric structure, with gas inlets 5a, 5b, providing two equal and constant gas flow rates towards the substrate. Vertically impinging gas flows 6a, 6b may each be divided in two flows running in parallel with the substrate 11. A central exhaust channel 14c is used to guide opposite flows to a central symmetry plane of the plasma delivery apparatus, where the two flows may merge. For obtaining sharp edge profiled deposition-free areas, a limited width of the central exhaust channel 16c is essential. However, for an effective plasma exhaust, the width of the exhaust channel is typically two times larger than the gap distance between the outer face 10 of plasma delivery apparatus 100 and substrate width. Practical values for the width of plasma exhaust channels are in the range 0.2 - 1.0 mm and preferably in the range 0.2-0.5 mm.

Another requirement for obtaining sharp edge profiled deposition-free areas in a cyclic Spatial ALD process, is the switch circuit operating in unison with the transport mechanism. This may be provided by alignment means known to the skilled person, such as, in case of roll-to-roll treatment of flexible substrates, a marker pattern at one or both border areas of the moving substrate can be used. The marker pattern may be read by a sensor (optical) whose signal is then used to synchronize substrate position and plasma power supply switch controllers. The marker pattern can be used as well for controlled substrate alignment in the direction perpendicular to movement.
Polymer substrates such as PET substrates tend to expand or shrink with temperature variation compromising the accuracy of position control. However, since the applied plasma treatment is non-thermal (causing a substrate temperature change of less than 2-5 degrees), the proposed method is particularly well suited for heat-sensitive substrates.

For plasma-enhanced SALD of metal oxides, e.g. Al2O3, metal-organic precursors with high vapor pressure can be used, e.g. trimethylaluminium (TMA). As plasma gas composition 0.5-2% O2-N2 gas mixtures can be used. Alternatively other oxygen containing gasses can be used such as CO2 or N2O as long as for a given process temperature those gases do not react with the metal-organic precursor chemisorbed on the substrate.
The intended deposition-free area may be not fully deposition free as a result of radical diffusion and drag flow at high substrate velocities, impurities in the plasma gas such as H2O or even O2 reacting thermally with the metal organic or metal halide ALD precursor. Preferably the process is operated at low temperature, e.g. 100 degrees Celsius, where the thermal reaction can be avoided. For higher temperatures, e.g. > 150 degrees Celsius, it can be useful to apply an etching step at certain intervals of the repetitive SALD process. The SALD injection head may be equipped with an additional plasma source covering the entire substrate width in order to remove by plasma enhanced etching the non-intended thermally grown thin layers. A low concentration of H2 or NH3 in N2 may be used as plasma gas in the additional substrate-wide plasma source.
Alternatively, the proposed method can be used for local (patterned) plasma-etching of pre-deposited uniform thickness layers, maintaining relatively narrow width line shaped patterns while removing layer material outside those patterns. In addition, the layer surface may be exposed sequentially to an additional chemical component deposited over the entire area, using the plasma for local etching in a type of process known as Atomic Layer Etching (ALE).

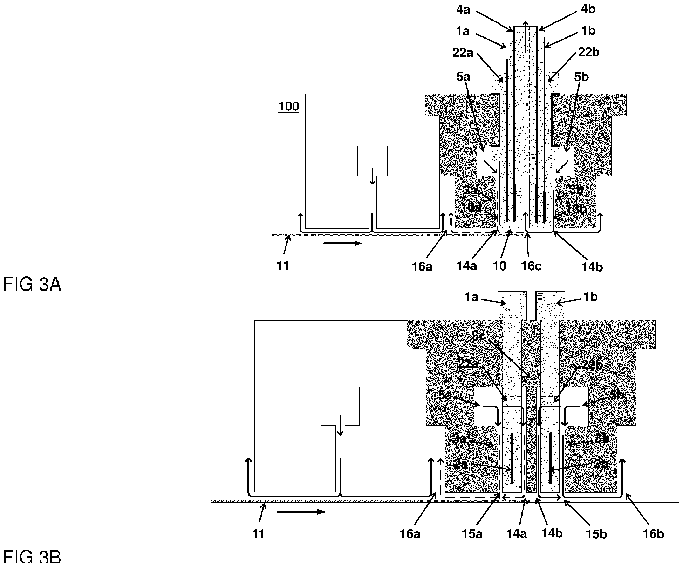

Fig. 3a shows a modified embodiment of the plasma delivery apparatus of Fig 1 in more detail. Both embodiments feature a plasma exhaust port 16c that is formed central to two plasma delivery ports 14a, 14b. The plasma activated gas flow, indicated as dashed line, is created in plasma generation space 13a in between working electrode 22a and grounded counter electrode 3a. The plasma zone extends from this generation space 13a further to a part of the outer face 10 of the dielectric structure parallel with the substrate. This provides a highly uniform plasma very nearby the substrate, potentially without using the substrate itself as electrode. One of the electrodes for DBD plasma generation is not covered by dielectric material. When both electrodes are covered by a dielectric, the time-averaged potential is not well defined causing a risk of filamentary plasma cross-over to conductive substrates. Preferably the plasma is generated using one uncovered electrode with defined voltage potential, preferably ground potential.
In this embodiment the plasma delivery ports 14a, 14b, each are adjacent to working electrodes 22a, 22b that are arranged on opposite sides of the central plasma exhaust port 16c. Working electrodes 22a, 22b and central plasma exhaust port 16c may be formed as a single dielectric structure. To prevent plasma forming in the plasma exhaust port, the port may be shielded from the working electrodes by adding ground electrode layers 4a, 4b to the dielectric structures 1a, 1b, which are also comprised in working electrodes 22a, 22b.
Additional functions of ground electrode layers 4a, 4b are:
o Increased radical density of surface DBD (SDBD) plasma created in parallel with the substrate, creating an increased radical flux towards the substrate, allowing for faster substrate movement under saturated ALD conditions.
o Control of the width of this SDBD plasma. The width should be less than 1 mm or less than 2 mm in order to avoid plasma-cross over to a conductive substrate for substrate gaps in the range 0.1-0.2 mm.
Dielectric structures 1a, 1b can also be manufactured as two separated monolithic ceramic plates with incorporated conductive layers using a manufacturing processes known as Low Temperature Co-fired Ceramics (LTCC) and High Temperature Co-fired Ceramics (HTCC). A single monolithic structure, incorporating the central exhaust channel 16c, shielding ground electrodes 4a, 4b and working electrodes 22a, 22b at both sides of this channel, offers important advantages. With a monolithic solid dielectric barrier structure dimensional tolerances of the plasma source and its assembly in a SALD injector head can be more easily achieved.

The combination of a central gas exhaust and a monolithic dielectric structure wherein this exhaust is integrated, offers additional benefits when both plasma sources are switched on, independent of the application for sharp edge profiled layer deposition:
- Both impinging gas flows are split-up, effectively distributing radicals to the substrate. In case the central exhaust would be absent, resulting in one left-side gas flow and one opposite right side gas flow, the radicals present in the upper section of flows along the substrate have a very low probability of reaction with the substrate. Splitting up each of the two vertical impinging gas flows, can be used for a higher radical flux or a lower gas consumption for a minimum required radical flux.
- Radicals react very rapidly with the substrate surface within the impingement zone, or are lost by recombination reactions in the gas phase. Even though the central exhaust is very nearby the impingement zones, horizontally separated by a short distance of ∼ 1 mm, this does not lead to important loss of radicals via the central exhaust. Thus the proposed geometry is both gas flow efficient and compact which are important factors for scaling-up plasma-enhanced SALD reactors.
- The proposed compact geometry offers an advantage with respect to contamination control. The plasma radical reaction with chemisorbed carbon containing ligands (generally -CHx) results in various volatile product. Ideally a reaction product leaves the reaction zone in the volatile phase (e.g. as CH4). However, also hydrocarbons with lower stability such as methanol (CH3OH) and formaldehyde (CH2O), reaction products designed by the general formula CxHyOz, may be formed. As a result carbon may also be included in the ALD layers compromising layer quality. In addition volatile reaction products may be formed which subsequently growth into particles which may be deposited on the spatial ALD injector head and on the substrate. A short residence time of volatile plasma reaction products is very important in order to avoid carbon inclusions in layers or other types of impurities and deposited particles on and within layers. The proposed geometry, where the residence time of volatile plasma products in the reactor has been minimized, is suitable for efficient removal of particles and volatile plasma reaction products by flow.
- The central exhaust channel can be equipped with a filter material for in-depth filtration (avoiding the risk of particles re-entering the deposition zone). A filter material may be catalytic. A filter material may be regenerated by remote plasma gaseous products (e.g. O3) or during maintenance by generating volume DBD plasma in the exhaust channel using electrodes 4a, 4b.

Fig. 3b presents an alternative design of the plasma delivery apparatus. In this embodiment, working electrodes 22a, 22b are arranged on opposite sides of a central counter electrode 3c, and centrally between counter electrodes 3a, 3b.
With respect to the embodiment of Fig. 3a, the main distinctive features are:
- Each of the switchable working electrodes 22a, 22b can be used to activate two plasma flows simultaneously, working electrode 22a for plasma delivered by ports 14a, 15a and working electrode 22b for plasma delivered by ports 14b, 15b.
- The flows from ports 15a, 15b may be less effective for delivering radicals directly to the substrate as these flows are on top of the flows from ports 14a, 14b. However, the effective radical flux may be enhanced as flows from ports 15a, 15b push down the flows from ports 14a, 14b towards the substrate. In particular, when the process is being operated at relatively large gaps between the outer face of plasma delivery apparatus 100 and the substrate 11, the effective radical flux towards the substrate can be enhanced.

- Dielectric structures 1a,b are not manufactured as single monolithic dielectric structure. However, their manufacturing is more simple incorporating a single conductive layer without central plasma exhaust channel.
- The working electrodes 22a, 22b are connected to the external switchable high voltage power supplies via a high voltage feed-through (not shown) oriented perpendicularly with respect to the cross section shown in Fig. 3b.

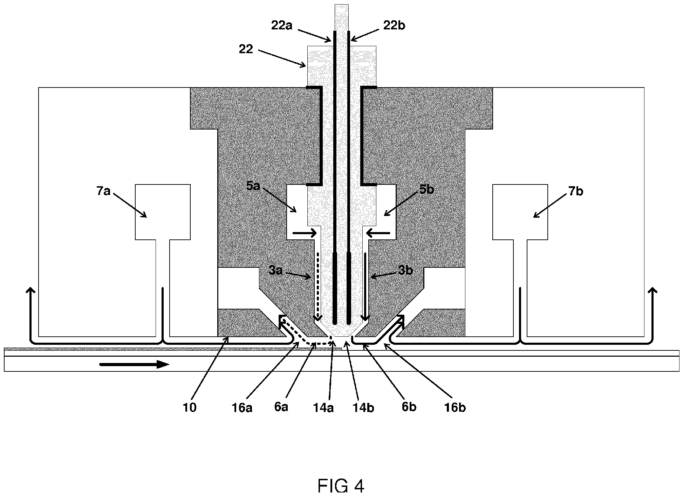

Fig. 4 shows a plasma delivery source having wedge shaped ground electrodes 3a, 3b. Wedge-shaped ground electrodes 3a, 3b may be important for extending remotely generated plasma with a section of surface DBD plasma in parallel with the substrate treating plane. Uniform surface DBD plasma can be created very proximate to the substrate without plasma cross-over to conductive substrates.
Grounded electrodes 3a, 3b and central ground electrode 3c in Figs. 3A and Fig. 3B may be equipped with small sized wedge shaped portions not shown in those Figs. New distinctive features are:
- A single monolithic formed working electrode arrangement 22, placed centrally between plasma exhaust ports 16a, 16b, comprising two independently switchable working electrodes 22a, 22b to activate selectively plasma in contiguous flows 6a, 6b in opposite directions.
- Plasma exhaust ports 16a, 16b, distanced from the plasma delivery ports 14a, 14b over half a thickness of a working electrode.

Fig. 5a shows a bottom view of the plasma source according the embodiment shown in Fig. 3a, 'seen' from the substrate. In order to separate plasma radicals in a direction perpendicular to substrate movement, separation gas inlets 31a, 31b have been provided. From the separation gas inlets, separation gas flows 32a, 32b create a radical free zone by modifications of the gas inlets, in a direction transverse to the substrate movement to supply push gas to a line shaped portion of the outer face in the direction of substrate movement. Thus an additional gas outlet 31a may have one or more modifications, in a direction transverse to the substrate movement to supply separation gas (alternatively named push gas) to a line shaped portion of the outer face in the direction of substrate movement.
It is emphasized that radical diffusion between parallel plasma-activated and neutral gas flows will be limited as a result of the short radical life time. For optimum effectiveness, it is important that separation gas inlets 31a,b are located nearby, preferably aligned with the slit shaped plasma delivery ports 14a, 14b. In addition or alternatively, when used in connection with atomic layer deposition, an additional slit-shaped co-reactant outlet may be arranged for providing an inert push gas, that pushes the co-reactant flow away from the outer face over a breadth of the additional gas outlet, to form a non-deposited area on the substrate extending along a transport direction. A possible plate-shape metallic or dielectric (e.g. ceramic) structure 30 transporting the neutral (not plasma activated) separation gas from plasma source gas inlets 5a, 5b towards separation gas inlets 31a, 32b, is shown in Fig. 5b that separates adjacent working electrodes arranged in line and provides a flow substantially equal to the plasma flow. Additional gas inlets for the separation gas are not needed.
In order to realize rectangular deposition (or etch) areas with different sizes within a single process, a spatial ALD injector head can be equipped with parallel series of plasma sources. Gas flows feeding a series of plasma sources temporarily not used can be switched off or to a lower level. Series of parallel and 'overlapping' plasma sources may also be used to deposit ALD films over the full substrate width. Thus according the invention, a spatial ALD head may be equipped with a number of plasma sources in order to deposit a combination of rectangular thin film areas of different sizes. The edge-profiled plasma treatment may also be applied for local etching of segments of pre-deposited thin films and for local surface activation (increasing surface energy).

Fig. 6 shows two cross sectional views of the monolithic dielectric structure according to Fig. 3a, incorporating line shaped conductive layer 2a, 2b, ground electrodes 4a, 4b and a central plasma exhaust port 16c. Ground screens 8a, 8b are provided for avoiding undesirable plasma formation between the dielectric structure and the plasma source housing.

Working electrodes 22a, 22b are connected to their respective high voltage terminals 9a via line shaped conductive layers 2a, 2b.
In spatial ALD a substrate is exposed sequentially to a coating precursor gas (e.g. trimethylaluminum (TMA) or trimethylindium (TMI)), purge gas to remove the non-surface-reacted precursor gases (N₂), the co-reactant (e.g. plasma generated radicals) and finally purge gas to remove the non-surface-reacted compounds (e.g. O₃, H₂O, H₂O₂).
In spatial ALD/ALE applications it is important to reduce the size of the injector head. It is emphasized that the thermally enhanced plasma injector is not intended for high temperature (thermal plasma). The increase of temperature reached by the dielectric barrier discharge plasma source is in the range 20-100 °C. Depending on gas flow rate and plasma power, in turn determined by the used voltage and frequency supplied by the electrical power generator, practical reached values of the temperature increase are 20-50 °C. As example, the heated DBD plasma source in operation can be used to process PET foil or any other temperature sensitive substrate at an average foil temperature of 100 °C using the injector head to rapidly layer-by-layer anneal the substrate top surface at 120-150 °C.

Where the term dielectric layer has been used, it should be appreciated that this layer need not have the same thickness everywhere. Although embodiments have been described wherein gas from the aperture additionally can be used to create a gas bearing between the outer face of the first electrode and the substrate, it should be appreciated that such a gas bearing is not always necessary. It is very useful if the substrate is a flexible foil, but when a rigid substrate is used (i.e. a substrate that does not deform to an extent that the distance to the outer face can vary significantly, e.g. more than twenty percent) another way of maintaining a distance between the outer face and the substrate may be used, such as contact spacers adjacent to ends of the aperture.

## Claims

1. A plasma delivery apparatus, comprising:
- a plasma source provided in an outer face of the delivery apparatus, the outer face arranged for facing a substrate to be treated;
- a transport mechanism configured to transport the substrate and the outer face relative to each other;
- the plasma source comprising a gas inlet to provide gas flow to a plasma generation space;
- the plasma generation space fluidly coupled to at least one plasma delivery port arranged in the outer face; wherein the plasma generation space is bounded by an outer face of a working electrode and a counter electrode; the working electrode comprising a dielectric layer;
- at least one plasma exhaust port provided in the outer face and distanced from the plasma delivery port, to exhaust plasma flowing along the outer face via said plasma exhaust port,
- wherein said at least one plasma delivery port and at least one plasma exhaust port are arranged to provide at least two contiguous plasma flows flowing in opposite directions that are each generated by a respective one of at least two working electrodes; and a switch circuit for switchably providing an electric voltage to the at least two working electrodes, wherein the switch circuit operates in unison with the transport mechanism.

2. The plasma delivery apparatus according to claim 1, wherein the plasma exhaust port and plasma delivery ports are formed by slits that are distanced over a thickness of a working electrode.

3. The plasma delivery apparatus according to any preceding claim, wherein a plasma exhaust port is formed central to plasma delivery ports.

4. The plasma delivery apparatus according to claim 3, wherein the plasma delivery ports each comprise working electrodes that are arranged on opposite sides of the plasma exhaust port.

5. The plasma delivery apparatus according to claim 4, wherein the plasma exhaust port is shielded from the working electrodes by ground electrodes on opposite sides of the exhaust port.

6. The plasma delivery apparatus according to any preceding claim, wherein a plasma delivery port is provided central to plasma exhaust ports.

7. The plasma delivery apparatus according to claim 6, wherein the plasma delivery port is fluidly connected with two plasma generation spaces arranged on opposite sides of a central working electrode arrangement, the working electrode arrangement comprising at least two switchable working electrodes each adjacent one of the two plasma generation spaces.

8. A plasma delivery apparatus according to any of the previous claims, wherein a plasma delivery port comprises an additional gas outlet for providing a push gas, that pushes the plasma flow away from the outer face over a breadth of the additional gas outlet, to form a non-deposited area on the substrate extending along a transport direction.

9. A plasma delivery apparatus according to claim 8, wherein said additional gas outlet has one or more modifications, in a direction transverse to the substrate movement to supply push gas to a line shaped portion of the outer face in the direction of substrate movement.

10. An atomic layer processing apparatus, comprising a plasma delivery apparatus according to any of the previous claims, and coreactant delivery system arranged to deliver a coreactant flow to the substrate in alternating fashion to the plasma delivery apparatus.

11. An atomic layer processing apparatus, according to claim 10, wherein the coreactant delivery comprises an additional gas outlet for providing a push gas, that pushes the coreactant flow away from the outer face over a breadth of the additional gas outlet, to form a non-deposited area on the substrate extending along a transport direction.
